# EUROPEAN PATENT SPECIFICATION

(11) **EP 2 743 712 B1**
(45) Date of publication and mention of the grant of the patent: **10.10.2018**
(21) Application number: 12196504.0
(22) Date of filing: 11.12.2012
(51) Int. Cl.: G01R 31/00, G01R 31/02

(54) **Testing device and method of testing**
Testvorrichtung und Testverfahren
Dispositif de test et procédé de test

(43) Date of publication of application: 18.06.2014
(73) Proprietor: Bombardier Transportation GmbH, 10785 Berlin (DE)
(72) Inventor: Maistrello, Simone, 17041 Altare (IT)
(74) Representative: Ramrath, Lukas

(56) References cited:
- EP-A2- 0 314 375
- DE-A1- 19 721 453
- GB-A- 2 226 642
- US-A- 4 418 312
- US-A1- 2002 045 996

## Description

The invention relates to a testing device for testing an electric connectivity of an electric connection, in particular an electric connection provided by a vehicle bus system, more particular an electric connection comprising at least one galvanic separation. Furthermore, the invention relates to a method of testing an electric connectivity of such an electric connection.

Vehicle bus systems provide an electrical connection between different electronic devices of the vehicle.

In rail vehicles, control devices such as an air conditioning control device, a traction control device or a ventilation control device are used to control separate processes of the rail vehicle. To connect these control devices and other devices of the vehicle, a vehicle bus system, in particular a train communication network, more particular a multifunction vehicle bus, can be used. Such a vehicle bus system allows to transmit electric signals to other devices and to receive electric signals sent from other devices. This, in turn, allows communication between said electronic devices.

Some electronic devices connected to the vehicle bus system comprise a galvanic separation, e.g. provided by a transformer integrated into such an electronic device. In this case, the vehicle bus is interrupted for DC (direct current) signals. If e.g. a primary winding of the transformer is connected to a phase line and a reference line of the vehicle bus system, a short circuit of the respective bus line is provided for DC signals.

In case of a vehicle bus system comprising such a galvanic separation, continuity testing of the bus lines which are e.g. provided by a cable, in particular an electric twisted pair cable, cannot be performed using standard DC testing technologies or standard devices.

The US 6,118,281 discloses a method for determining the shielding effectiveness of a shielded and, particularly, permanently installed cabling path, wherein the cabling path has an inside conductor connected via a patching cable at a first end to a transmitter which emits an electric test signal. One pole of the transmitter output is applied to a ground potential and the other pole is conductively connected to a patching cable. At a second end of the shielded cabling path, the shielding is applied to ground potential and conductively connected to the inside conductor via a terminating impedance. The method comprises the steps of connecting the shielding of the shielded cabling path to the second pole of the transmitter output by a return line, wherein the return line has a predetermined impedance and is connected to the first end of the shielded cabling path. Furthermore, a differential current intensity of currents flowing through the patching cable and the return line are converted into a measured value using a measuring device. Further, a theoretical reference value for a corresponding cabling path with interrupted shielding is defined and a value which is representative of the shielding effectiveness of the shielding cabling path is determined using both, the measured value and the theoretical reference value.

The EP 0 075 418 A1 discloses a pulse echo equipment including a transmitter arranged to apply test pulses to an end of a cable system. Further, the equipment includes a circuit means arranged to receive echo pulses generated in the cable system and a voltage measuring circuit arranged to measure the average voltage of echo pulses and arranged to monitor the echo pulses over a very short interval of time selectively interspaced between the application of test pulses. The voltage measured is dependent on the impedance characteristics of a selected short length of the cable.

The WO 99/39493 discloses a connection testing device for testing connections in telecommunications cabling. The testing device comprises at least one multi-terminal pair plug-in module for insertion into one of a plurality of corresponding multi-terminal pair connection or disconnection blocks. Further, the testing device comprises serial switching means for sequentially switching through individual terminal pairs in the block, each terminal pair being arranged to receive first and second wiring legs. Further, the testing device comprises parallel switching means for selectively connecting or disconnecting in parallel all of the terminal pairs in the block and indicator means for indicating when a valid or invalid connection has been established in respect both of a particular block and of the terminal pairs in the block.

The DE 197 21 453 A1 discloses a device for testing cables with n cable cores. The device comprises an input-sided feed circuit and an output-sided evaluation and display circuit.

It is an object of the invention to provide a testing device and a method of testing an electric connectivity of an electric connection, in particular an electric connection comprising a galvanic separation, more particular an electric connection of a vehicle bus system, which provides robust and correct testing results for a large number of electric connections, in particular in the case that the electric connection has already been assembled on the vehicle.

It is a main idea of the proposed invention to provide an AC (alternating current) test signal to one single phase line of the electric connection, wherein all other phase lines of the electric connection are connected to a reference potential. Furthermore, the test signal applied to a first end of the electric connection is rectified at another end of the electric connection, wherein the rectified signal is applied to an indication means.

The proposed invention can be used for testing an electric connectivity of a large number of electric connections. In particular, the proposed invention can be used to test the electric connectivity of an electric connection in a vehicle bus system, in particular in a multifunctional vehicle bus. The vehicle bus system can be a bus system of any type of vehicle. In particular, the present invention can be applied to a bus system of any land vehicle, including but not preferably, any vehicle which is only temporarily on land, in particular track-bound vehicles, such as rail vehicles (e.g. trams), but also to road automobiles, such as individual (private) passenger cars or public transport vehicles (e.g. busses including trolley buses), which are also track-bound vehicles).

In particular, the present invention can be used to test a complete bus network, in particular a multifunctional vehicle bus (MVB), wherein the MVB can comprise an EMD (electric middle distance) bus (MVB EMD) which is, inter alia, designed to interconnect electronic devices comprising a transformer.

A testing device for testing an electric connectivity of an electric connection, in particular in electric connection comprising a galvanic separation, e.g. a transformer, is proposed. The electric connection comprises at least a first phase line and a reference line. The electric connection can be provided by a cable. The cable can comprise multiple phase lines and/or a cable shield which can provide the reference line. It is possible that the cable is a twisted pair cable or a twisted two pair cable.

The testing device comprises a transmitting unit and a receiving unit. The transmitting unit or transmitting device and the receiving unit or receiving device are designed as separate devices. The transmitting unit is connectable to a signal generator via an input port of the transmitting unit, wherein the input port comprises at least one signal connecting means and one reference connecting means. A connecting means can e.g. be designed as a pin or any other type of electric connector. The signal connecting means can be connected to a signal output of the signal generator. A reference connecting means can be connected to a reference potential, which can e.g. be provided by the signal generator or can be any other type of reference potential, e.g. a ground line.

The signal connecting means of the input port of the transmitting unit is electrically connected to a signal part of the transmitting unit. The reference connecting means of the input port of the transmitting unit is electrically connected to a reference part of the transmitting unit. The signal part denotes a part or a circuit part of the transmitting unit which carries a signal potential if the transmitting unit is connected to the signal generator. The reference part denotes a part or circuit part of the transmitting unit which carries the reference potential, if the reference connecting means of the input port are connected to said reference potential. Thus, the signal part and the reference part of the transmitting unit are designed as electrically isolated parts or circuit parts of the transmitting unit.

The transmitting unit is connectable to the electric connection, e.g. the electric cable, via an output port, wherein the output port of the transmitting unit comprises at least one signal connecting means and one reference connecting means. The signal connecting means of the output port of the transmitting unit is connectable to the first phase line, in particular at a first end of the electric connection. The reference connecting means of the output port is electrically connectable to the reference line of the electric connection, in particular at the first end of the electric connection. Again, a connecting means can be provided or designed as a pin or any other type of electrical connector.

The signal connecting means of the output port of the transmitting unit is electrically connectable to the signal part of the transmitting unit. It is possible that the signal connecting means of the output port of the transmitting unit is additionally electrically connectable to the signal part of the transmitting unit. The reference connecting means of the output port is electrically connected to the reference part of the transmitting unit.

Furthermore, the receiving unit comprises an input port, at least a first rectifying means and at least a first signal indication means. The receiving unit is connectable to the electric connection via the input port, wherein the input port comprises at least one signal connecting means and one reference connecting means. The signal connecting means of the input port of the receiving unit is electrically connectable to the first phase line, in particular at another end of the electric connection. The reference connecting means of the input port of the receiving unit is connectable to the reference line, in particular at the other end of the electric connection.

The signal connecting means of the input port of the receiving unit is connected to the reference connecting means of the input port of the receiving unit via a first series connection, wherein the first series connection comprises at least the first rectifying means and the first signal indication means. If a signal generator is connected to the transmitting unit and the electric connection, e.g. the cable, is arranged and connected in between the transmitting and the receiving unit, an AC signal generated by the signal generator can be applied to the first phase line of the electric connection at a first end of the electric connection via the transmitting unit. In case of a faultless or intact electric connection, the AC test signal will be received at the other end of the electric connection by the receiving unit, wherein the AC test signal will be rectified and applied to the first indication means.

A rectifying means denotes a device which generates a DC signal out of an AC signal. A rectifying means can e.g. be provided by a half-wave rectifier or a full-wave rectifier. The rectifying means can be provided by a passive rectifier, which only comprises passive electric or electronic elements such as diodes. Alternatively, the rectifying means can be provided by an active rectifier, wherein the active rectifier comprises active electric or electronic devices such as switching elements, in particular IGBT, MOSFET and/or thyristors.

The signal indication means denotes a device which generates an indication signal out of the rectified DC signal. An indication signal can be an optic signal, acoustic signal, and/or haptic signal and/or any other type of signal.

The proposed testing device includes the transmitting unit and the receiving unit. Each of these units, however, can be an object of an independent invention.

The proposed testing device provides a simple and cheap testing device which can be manufactured by using off-the-shelf components. The usability of the proposed testing device is simple which advantageously allows testing performed by non-expert users.

Using the proposed testing device, it is possible to test an electric connection even after a final assembly of the vehicle, wherein the electric connection is already installed within the vehicle and electronic devices are already connected by the electric connection. Furthermore, the proposed testing device provides a robust indication of a faulty or faultless electric connection.

The main advantage, however, is that the proposed testing device allows testing an electric connectivity of an electric connection which comprises a galvanic separation, e.g. provided by a transformer which is part of an electronic device connected by said electric connection. In case of a DC test signal, such a galvanic separation would, as described previously, provide an interruption or a short circuit of the tested electric connection. For an AC test signal, however, the galvanic separation can provide an element with high impedance but not a short circuit anymore.

This allows testing of the electric connection with a high and robust testing quality.

According to the invention, the transmitting unit is connectable to a multiphase cable comprising n phase lines via the output port of the transmitting unit. The transmitting unit comprises at least one switching means, wherein the switching means is designed and arranged such that in each switching configuration one of n signal connecting means of the output port of the transmitting unit is connected to the signal part of the transmitting unit. The switching means can be arranged within and/or connected to the previously described circuit parts providing the signal part and the reference part of the transmitting unit. The remaining n-1 signal connecting means of the output port of the transmitting unit are connected to the reference part of the transmitting unit. This means that the switching means is designed and arranged such that in each switching configuration only one single phase line of the electric connection to be tested is connected to the signal part, wherein all remaining phase lines are connected to the reference part.

The receiving unit is connectable to the multiphase cable via the input port of the receiving unit, wherein the receiving unit comprises n rectifying means and n signal indication means. Each of the n signal connecting means of the input port of the receiving unit is connected to the corresponding reference connecting means of the input port of the receiving unit via a series connection. Each of the series connections comprises at least one rectifying means and one signal indication means.

This advantageously allows testing electric connections provided by each of n phase lines of e.g. a cable. As only one single phase line is connected to the signal part and all remaining phase lines to the reference part, signal coupling between the phase lines is advantageously avoided. This, in turn, increases the robustness and testing quality.

In another embodiment, the signal indication means is designed as a light emitting diode. This advantageously allows generating an optic indication signal which can be easily perceived by a user even in a noisy environment.

In another embodiment, the rectifying means is designed as a diode. This advantageously provides a simple realization of the rectifying means using a standard, off the-shelf element.

In another embodiment, each of the series connections comprises a resistive element. Alternatively, all of the series connections are connected to the reference connecting means of the input port of the receiving unit via a common resistive element. This advantageously allows adjusting a voltage drop across the signal indication means, in particular the previously described light emitting diode.

In another embodiment, a capacitive element is connected in parallel to a current path comprising the signal indication means. In particular, the capacitive element can be connected in parallel to a current path comprising a series connection of the signal indication means and the previously described resistive element.

This advantageously allows smoothing the rectified test signal.

In another embodiment, the transmitting device comprises n-1 double switching elements. A double switching element denotes an element which has only two switching states or switching configurations. In a first switching state, a first input of the double switching element is connected to a first output of the double switching element and a second input of the double switching element is connected to a second output of the double switching element. In the second switching state, the first input of the double switching element is connected to a third output of the double switching element and the second input of the double switching element is connected to a fourth output of the double switching element. The switching element can be designed such that it is manually operable. This means that user can change switching states manually.

The switching elements are arranged within and/or connected to the circuit parts, in particular the signal circuit part and the reference circuit part, of the transmitting unit such that in each configuration of the n-1 double switching elements, only one signal connecting means of the output port of the transmitting unit is connected to the signal part of the transmitting unit, wherein all other signal connecting means of the output port of the transmitting unit are connected to the reference part.

This advantageously provides a testing device which is easily to be operated.

In other embodiment, the testing device comprises a signal generator. The signal generator is connected to the transmitting unit via the input port of the transmitting unit. In particular, the signal generator is an AC signal generator.

In another embodiment, the signal generator is a square wave generator. A square wave test signal advantageously comprises a wide range of frequencies. A galvanic separation, e.g. a transformer, within the tested electric connection will provide different impedances for each of these frequencies. Using such a square wave signal advantageously increases the probability that an electric signal is received by the receiving unit.

In another embodiment, the output port of the transmitting unit comprises four signal connecting means. Furthermore, the input port of the receiving unit comprises four signal connecting means, wherein the receiving unit comprises four series connections of rectifying means and signal indication means.

This advantageously allows testing an electric cable comprising two twisted pair conductors and a cable shield. Such a cable is used within the aforementioned EMD MVB as defined by the IEC61375 standard. But the proposed device can also be used for testing Ethernet patch cables, CAN cables, bus cables of a LON, LIN or any other type of bus cable.

Further proposed is a method of testing an electric connectivity of an electric connection, wherein the electric connection comprises at least a first phase line and a reference line. The method comprises the steps of:
- connecting a signal generator to a transmitting unit via an input port of the transmitting unit. The transmitting unit is designed according to the previously described embodiments of the testing device including such a transmitting unit.
- connecting the first phase line at a first end of the electric connection to a signal connecting means of an output port of the transmitting unit,
- connecting the signal connecting means of the output port of the transmitting unit to the signal part of the transmitting unit, e.g. by operating switching elements which will be explained later,
- connecting the reference line at the first end of the electric connection to the reference connecting means of the output port of the transmitting unit,
- connecting the phase line at another end of the electric connection to a signal connecting means of an input port of a receiving unit, wherein the receiving unit is designed according to the previously described embodiments of the testing device which includes such a receiving unit,
- connecting the reference line at the other end of the electric connection to a reference connecting means of the input port of the receiving unit,
- generating an AC test signal.

This advantageously provides a method of testing an electric connectivity of an electric connection which is easy to be performed using the proposed testing device.

According to the invention, n phase lines of the electric connection are connected to the transmitting unit via the output port of the transmitting unit at the first end of the electric connection. One of n signal connecting means of the output port of the transmitting unit is connected to the signal part of the transmitting unit and the remaining n-1 connecting means of the output port of the transmitting unit are connected to the reference part of the transmitting unit by operating a switching means of the transmitting unit. By operating the switching means, only one single phase line of the electric connection is connected to the signal part, wherein all remaining phase lines are connected to the reference part automatically.

Each phase line is connected via a series connection of a signal rectifying means and a signal indication means to the reference line at another end of the electric connection, wherein the series connections are provided by the aforementioned receiving unit.

This advantageously provides a method of testing with an increased operational safety, in particular if (an) electric connection(s) provided by a multiphase cable is/are tested.

In another embodiment, one of n signal connecting means of the output port of the transmitting unit is connected to the signal part of the transmitting unit and the remaining n-1 connecting means of the output port of the transmitting unit are connected to the reference part of the transmitting unit by selecting a switching state of each of n-1 double switching elements.

This advantageously further enhances the practicability of the proposed method.

In another embodiment, the AC testing is a square wave signal. As described previously, such an AC test signal comprises a large range of frequency which corresponds to a wide spectrum. This advantageously allows testing electric connections comprising all kinds of galvanic separations, e.g. transformers.

In another embodiment, the square wave signal has a frequency of 1 MHZ.

The invention will be described with reference to the attached Figures. The Figures show:
- Fig. 1: a schematic block diagram of a testing scenario,
- Fig. 2: a schematic circuit diagram of a transmitting unit,
- Fig. 3: a schematic circuit diagram of a receiving unit and
- Fig. 4: a top view on a transmitting unit.

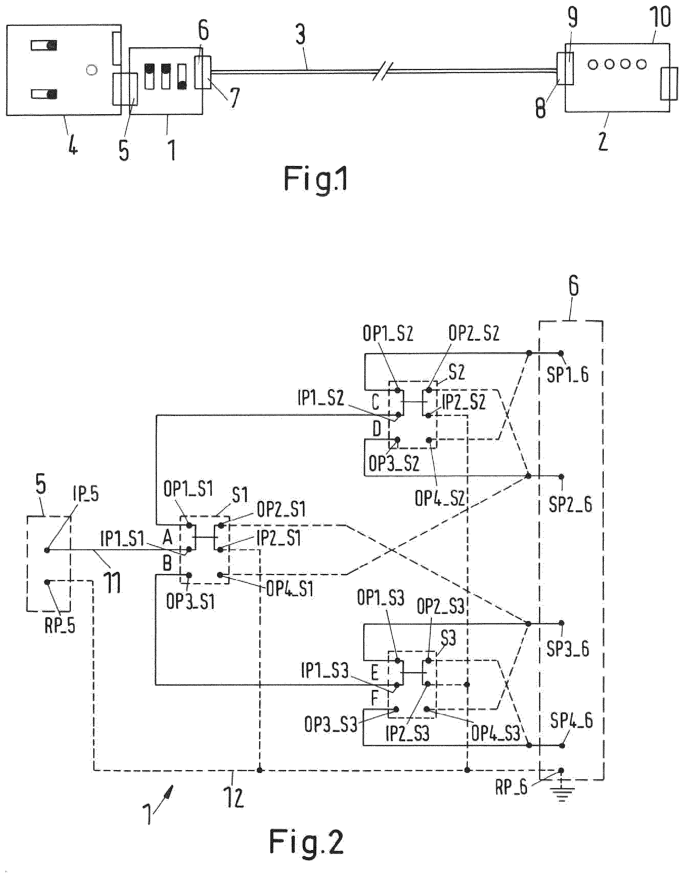

Fig. 1 shows a schematic block diagram of a testing scenario. A testing device comprising a transmitting unit 1 and a receiving unit 2 is used to test an electric connectivity of a cable 3, wherein the cable 3 is an element of a multifunctional vehicle bus system, in particular of an electrical middle distance multifunctional vehicle bus system. Such a cable 3 may comprise two twisted pair conductors (not shown) wherein each conductor provides two phase lines. By using such a cable 3, electronic devices (not shown), in particular electronic devices comprising a transformer, can be electrically connected.

Furthermore, a signal generator 4 is shown which is connected to the transmitting unit 1 via an input port 5 of the transmitting unit 1. The cable 3 is connected to the transmitting unit 1 via an output port 6 of the transmitting unit 1 at a first end 7 of the cable 3. At another end 8 of the cable 3, the cable 3 is connected to the receiving unit 2 via an input port 9 of the receiving unit 2. Also shown is an output port 10 of the receiving unit 2 which allows further connection of another electric cable (not shown) such that the tested bus system is not interrupted while testing is performed. The signal generator 4 generates a square wave signal. It is possible that an electronic or electric device is arranged between the first end 7 and the other end 8.

By using the shown testing device, it is possible to inject a radio-frequency signal into a phase line of the cable 3.

The cable 3 further comprises a cable shield (not shown) which provides a reference line of the electric connection.

The shown testing device can be also used to test an electric connectivity of another cable which e.g. provides an electric short distance (ESD) MVB (MVB ESD) or optical coupling bus of electronic devices. A cable providing an electric connection of such a bus system can also comprise four conductors each providing a phase line and two additional conductors to balance the ground potential of the cable providing the MVB ESD.

The cablings of the aforementioned cable providing the MVB EMD system cannot be tested by using a simple ohmic continuity test if the coupling transformers are arranged within one or more of the phase lines provided by the cable 3. These transformers provide short circuits for DC test signals.

In Fig. 2 a schematic circuit diagram of the transmitting unit 1 is shown. The transmitting unit 1 comprises an input port 5 which comprises a signal input pin IP_5 and a reference pin RP_5. Furthermore, the transmitting unit 1 comprises an output port 6 which comprises a first signal pin SP1_6, a second signal pin SP2_6, a third signal pin SP3_6, a fourth signal pin SP4_6 and a reference pin RP_6.

Furthermore, the transmitting unit 1 comprises an input part 11 and a reference part 12. The input signal pin IP_5 of the input port 5 of the transmitting unit 1 is electrically connected to the input part 11. The reference pin RP_5 of the input port 5 of the transmitting unit 1 is electrically connected to the reference part 12 of the transmitting unit 1. The reference pin RP_6 of the output port 6 of the transmitting unit 1 is electrically connected to the reference part 12. All signal pins SP1_6, SP2_6, SP3_6, SP4_6 are electrically connectable to the signal part 11 via switches S1, S2, S3. The switches S1, S2, S3 are designed as double switching elements. Each of the switches S1, S2, S3 comprises two input pins IP1_S1, IP2_S1, IP1_S2, IP2_S2, IP1_S3, IP2_S3. Also, each switch S1, S2, S3, S4 comprises four output pins OP1_S1, OP2_S1, OP3_S1, OP4_S1, OP1_S2, OP2_S2, OP3_S2, OP4_S2, OP1_S3, OP2_S3, OP3_S3, OP4_S3. In a first switching state A, C, E of each switch S1, S2, S3, the first input pin IP1_S1, IP1_S2, IP1_S3 is connected to the first output pin OP1_S1, OP1_S2, OP1_S3, respectively. Also, the second input pin IP2_S1, IP2_S2, IP2_S3 is connected to the second output pin OP2_S1, OP2_S2, OP2_S3, respectively.

In a second switching state B, D, F of each switch S1, S2, S3, the first input pin IP1_S1, IP1_S2, IP1_S3 is connected to the third output pin OP3_S1, OP3_S2, OP3_S3, respectively. Also the second input pin IP2_S1, IP2_S2, IP2_S3 is connected to the fourth output pin OP4_S1, OP4_S2, OP4_S3, respectively. The switching states A, B, C, D, E, F of each switch S1, S2, S3 can be changed independently with respect to the remaining switches S1, S2, S3. If the first switch S1 is in the first switching state A, the second switch S2 is in the first switching state C and the third switch S3 is in the first switching state E, the first signal pin SP1_6 of the output port 6 is connected to the signal part 11. All the remaining signal pins SP2_6, SP3_6, SP4_6 are connected to the reference part 12.

If the first switch S1 is in the first switching state A, the second switch S2 is in the second switching state D, and the third switch S3 is in the first switching state E, the second signal pin SP2_6 is connected to the signal part 11, wherein the remaining signal pins SP1_6, SP3_6, SP4_6 are connected to the reference part 12. If the first switch S1 is in the second switching state B, the second switch S2 is in the second switching state D, and the third switch S3 is in the first switching state E, the third signal pin SP3_6 is connected to the signal part 11, wherein the remaining signal pins SP1_6, SP2_6, SP4_6 are connected to the reference part 12. If the first switch S1 is in the second switching state B, the second switch S2 is in the second switching state D, and the third switch S3 is in the second switching state F, the fourth signal pin SP4_6 is connected to the input part 11, wherein the remaining signal pins SP1_6, SP2_6, SP3_6 are connected to the reference part 12.

This is achieved by connecting the first output pin OP1_S1 of the first switch S1 to the first input pin IP1_S2 of the second switch S2. Also the first signal pin SP1_6 is connected to the first output pin OP1_S2 and to the fourth output pin OP4_S2 of the second switch S2. The second signal pin SP2_6 is connected to the third output pin OP3_S2, to the second output pin OP2_S2 of the second switch S2 and to the fourth output pin OP4_S1 of the first switch S1. The third signal pin SP3_6 is connected to the first output pin OP1_S3, to the fourth output pin OP4_S3 of the third switch S3 and to the second output pin OP2_S1 of the first switch S1. The fourth signal pin SP4_6 is connected to the third output pin OP3_S3 and to the second output pin OP2_S3 of the third switch S3. All second input pins IP2_S1, IP2_S2, IP2_S3 are connected to the reference part 12. Also, the third output pin OP3_S1 of the first switch S1 is connected to the first input pin IP1_S3 of the third switch S3.

The pins IP_5, RP_5 of the input port 5 of the transmitting unit 1 can be provided by "pin 1" and "pin 2" of a nine-pin male solder connector. The signal pins SP1_6, SP2_6, SP3_6, SP4_6 can be provided by "pin1", "pin 2", "pin 4", "pin 5" of a nine-pin female solder connector. In this case, the reference part 12 can be electrically connected to the connector's metal shell.

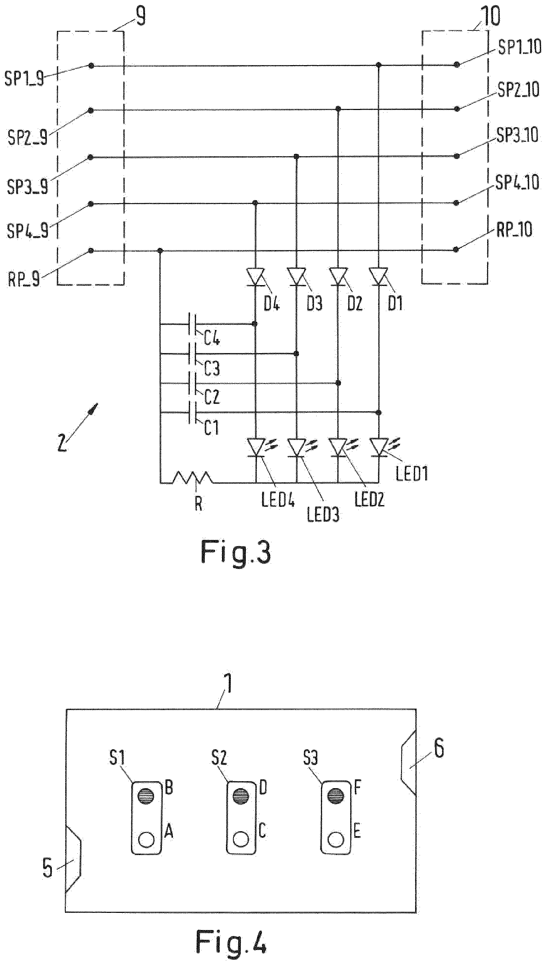

Fig. 3 shows a schematic circuit diagram of a receiving unit 2. The receiving unit 2 comprises an input port 9 and an output port 10. The input port 9 comprises a first signal pin SP1_9, a second signal pin SP2_9, a third signal pin SP3_9, a fourth signal pin SP4_9 and a reference pin RP_9.

The signal pins SP1_9, SP2_9, SP3_9, SP4_9 of the input port 9 of the receiving unit 2 can be provided by "pin 1", "pin 2", "pin 4", "pin 5" of a nine-pin male solder connector. The output port 10 comprises signal pins SP1_10, SP2_10, SP3_10, SP4_10 and a reference pin RP_10 which are connected to the corresponding signal pins SP1_9, SP2_9, SP3_9, SP4_9, respectively. Also, reference pins RP_9, RP_10 of the input port 9 and the output port 10 are electrically connected.

The first signal pin SP1_9 of the input port 9 of the receiving unit 2 is connected to the reference pin RP_9 of the input port of the receiving unit 2 via a series connection, wherein the series connection comprises a first diode D1, a light emitting diode LED1 and a resistor R. In parallel to the series connection of the first light emitting diode LED1 and the resistor R, a first capacitor C1 is arranged. Correspondingly, each of the remaining signal pins SP2_9, SP3_9, SP4_9 is connected to the reference pin RP_9 via series connections, wherein each series connection comprises a diode D2, D3, D4, a light emitting diode LED2, LED3, LED4, and the resistor R. As in the first series connection, capacitors C2, C3, C4 are arranged in parallel to the series connections of the light emitting diodes LED2, LED3, LED4 and the resistor R, respectively.

The resistor can have a resistance of preferably 80 to 100 Ohm. The capacitors C1, C2, C3, C4 can have a capacitance of approximately 100 pF. The diodes D1, D2, D3, D4 can be Schottky diodes.

In Fig. 4 a top view on a transmitting unit 1 is shown. The transmitting unit 1 comprises an input port 5 and an output port 6. Shown are also a first switch S1, a second switch S2 and a third switch S3. Shown are also switching states A, B, C, D, E, F of the switches S1, S2, S3, wherein the switches S1, S2, S3 can be switched between a first switching state A, C, E and a second switching state B, D, F (see also Fig. 2).

If the cable 3 (see Fig. 1) is faultless, i.e. there is no faulty electric connection, an AC test signal which is generated by the signal generator 4 will be received by only one signal pin SP1_9, SP2_9, SP3_9, SP4_9 of the input port 9 of the receiving unit 2. Correspondingly, only the corresponding light emitting diode LED1, LED2, LED3, LED4 will light up. In this case, the cabling provided by the cable 3 is correct and electric continuity is guaranteed even at radio frequency. Such a test can be conducted for all phase lines of the cable 3 which are connected to the signal pins SP1_6, SP2_6, SP3_6, SP4_6 of the output port 6 of the transmitting unit 1 and to the signal pins SP1_9, SP2_9, SP3_9, SP4_9 of the input port 9 of the receiving unit 2, respectively. If, as described previously, nine-pine connectors are used, the metal shell of each connector should be connected to the reference pins RP_5, RP_6, RP_9, RP_10 of each input or output port 5, 6, 9, 10.

A reversed pin can be detected if a light emitting diode LED1, LED2, LED3, LED4 other than the light emitting diode LED1, LED2, LED3, LED4 related to or corresponding to the tested phase line lights up.

A disconnected pin and therefore an interrupted phase line of the cable 3 can be detected if the corresponding light emitting diode LED1, LED2, LED3, LED4 does not light up. It is to be noted, however, that, if there is a strong capacitive coupling between the phase lines, a signal with a high signal level such as five volts can generate a signal in the tested phase line which may lead to a dimly light up of the light emitting diode LED1, LED2, LED3, LED4 of the tested cable.

If a pin is shortened to another pin or to the cable shield or a phase line is shortened to another phase line or to the cable shield, different scenarios may occur. In the case of a short circuit between two phase lines, for example, since there are about 100 meters of cable, an impedance between the first end 7 of the cable 3 and the other end 8 of the cable 3 is still perceptible. Such a short circuit can lead to the following scenarios, depending on where the short circuit occurs.

A short circuit near the signal generator 4 can be detected, if the light emitting diode LED1, LED2, LED3, LED4 corresponding to the tested phase line does not light up. A short circuit, wherein the phase line is shortened to the cable shield, near the receiving unit 2 may be detected if no light emitting diode LED1, ..., LED4 lights up. If the phase line is shortened to another phase line, the light emitting diode LED1, ..., LED4 corresponding to the tested phase line can light up (or light up weakly), because the series resistor R between the reference pin RP_9 and the point where the short circuit occurs may create a potential difference capable of lighting the light emitting diode LED1, ..., LED4. The short circuit in the middle of the cable 3 can be detected, if no light emitting diode LED1, ..., LED4 lights up.

In case of a capacitive coupling between two phase lines of the cable 3, the light emitting diode LED1, ..., LED4 corresponding to the tested phase line lights up and another light emitting diode LED1, ..., LED4 corresponding to another phase line may also light up dimly. Such a capacitive coupling can be avoided if the phase lines are connected in a compensated star connection.

During the testing of long sections of the cable 3 or of sections with several connected electronic devices (which can lead to a greater current flow to ground due to the parallel connection of the impedances of the decoupling transformers) it should be noted that the power supply battery of the signal generator 4 should be in a good condition so as to provide the necessary power to light up the light emitting diodes LED1, ..., LED4. A weak battery can affect the testing. Phase lines with less ohmic resistance compared to phase lines with a higher resistance can lead to an activation of the corresponding light emitting diode LED1, ..., LED4 while the test is performed, wherein the same testing performed on the phase line with the higher resistance will not activate the corresponding light emitting diode LED1, ..., LED4.

The proposed testing device and method of testing advantageously allows increasing the test coverage of a vehicle bus network, avoiding problems of wrong pin out, wire crossing, disconnected pins and bad cable assembly quality, among others. Also, the invention advantageously allows reducing the testing time during or after final assembly of the vehicle bus system. The testing device is also portable and allows simple debugging and troubleshooting commissioning or during warranty maintenance or after warranty maintenance. Another advantage is that the proposed testing device also allows shield continuity testing.

## Claims

1. Testing device for testing an electric connectivity of an electric connection, in particular an electric connection comprising a galvanic separation,
wherein the connection comprises at least a first phase line and a reference line,
wherein the testing device comprises a transmitting unit (1) and a receiving unit (2),
wherein the transmitting unit (1) is connectable to a signal generator (4) via an input port (5) comprising at least one signal connecting means and one reference connecting means, wherein the signal connecting means of the input port (5) is connected to a signal part (11) of the transmitting unit (1), wherein the reference connecting means of the input port (5) is connected to a reference part (12) of the transmitting unit (1),
wherein the transmitting unit (1) is connectable to the electric connection via an output port (6) comprising at least one signal connecting means and one reference connecting means, wherein the signal connecting means of the output port (6) is connectable to the first phase line, wherein the reference connecting means of the output port (6) is connectable to the reference line, wherein the signal connecting means of the output port (6) is connectable to the signal part (11) and the reference connecting means of the output port (6) is connected to the reference part (12),
wherein the receiving unit (2) comprises an input port (9), at least a first rectifying means and at least a first signal indication means, wherein the receiving unit (2) is connectable to the electric connection via the input port (9) comprising at least one signal connecting means and one reference connecting means, wherein the signal connecting means of the input port (9) is connectable to the first phase line, wherein the reference connecting means of the input port (9) is connectable to the reference line, wherein the signal connecting means of the input port (9) is connected to the reference connecting means of the input port (9) via a first series connection, wherein the first series connection comprises at least the first rectifying means and the first signal indication means, **characterized in that** the transmitting unit (1) is connectable to a multiphase cable comprising n phase lines via the output port (6), wherein
the transmitting unit (1) comprises at least one switching means, wherein the switching means is designed and arranged such that in each switching configuration one of n signal connecting means of the output port (6) is connected to the signal part (11) of the transmitting unit (1), wherein the remaining n-1 signal connecting means of the output port (6) are connected to the reference part (12) of the transmitting unit (1),
wherein the receiving unit (2) is connectable to the multiphase cable via the input port (9),
wherein the receiving unit (2) comprises n rectifying means and n signal indication means, wherein each of n signal connecting means of the input port (9) is connected to the reference connecting means of the input port (9) via a series connection, wherein each of the series connections comprises at least a rectifying means and a signal indication means.

2. The testing device according to claim 1, wherein the signal indication means is designed as a light emitting diode (LED1, LED2, LED3, LED4).

3. The testing device according to one of the claims 1 to 2, wherein the rectifying means is designed as a diode (D1, D2, D3, D4).

4. The testing device according to one of the claims 1 to 3, wherein each of the series connections comprises a resistive element or all of the series connections are connected to the reference connecting means of the input port (9) via a common resistive element.

5. The testing device according to one of the claims 1 to 4, wherein a capacitive element is connected in parallel to a current path comprising the signal indication means.

6. The testing device according to one of the claims 1 to 5, wherein the transmitting device (1) comprises n-1 double switching elements, wherein a first input of the double switching element is connected to a first output of the double switching element and a second input of the double switching element is connected to a second output of the double switching element in a first switching state (A, C, E), wherein the first input of the double switching element is connected to a third output of the double switching element and the second input of the double switching element is connected to a fourth output of the double switching element in a second switching state (B, D, F).

7. The testing device according to one of the claims 1 to 6, wherein the testing device comprises a signal generator (4), wherein the signal generator (4) is connected to the transmitting unit (2) via the input port (5) of the transmitting unit (2).

8. The testing device according to claim 7, wherein the signal generator (4) is a square wave generator.

9. The testing device according to one of the claims 1 to 8, wherein the output port (6) of the transmitting unit (1) comprises four signal connecting means, wherein the input port (9) of the receiving unit (2) comprises four signal connecting means, wherein the receiving unit (2) comprises four series connections of a rectifying means and a signal indication means.

10. Method of testing an electric connectivity of an electric connection, wherein the electric connection comprises at least a first phase line and a reference line, comprising the steps of:
- connecting a signal generator (4) to a transmitting unit (1) via an input port (5) of the transmitting unit (1),
- connecting the first phase line at a first end (7) of the electric connection to a signal connecting means of an output port (6) of the transmitting unit (1), wherein the signal connecting means of the input port (5) is connected to a signal part (11) of the transmitting unit (1), wherein the reference connecting means of the input port (5) is connected to a reference part (12) of the transmitting unit (1), wherein the reference connecting means of the output port (6) is connected to the reference part (12),
- connecting the signal connecting means of the output port (6) to the signal part (11), wherein n phase lines of the electric connection are connected to the transmitting unit (1) via the output port (6) at the first end (7) of the electric connection, wherein one of n signal connecting means of the output port (6) is connected to the signal part (11) of the transmitting unit (1) and the remaining n-1 connecting means of the output port (6) are connected to the reference part (12) of the transmitting unit (1) by operating a switching means of the transmitting unit (1),
- connecting the reference line at the first end (7) of the electric connection to the reference connecting means of the output port (6) of the transmitting unit (1),
- connecting the phase line at another end (8) of the electric connection to a signal connecting means of an input port (9) of a receiving unit (2),
- connecting the reference line at the other end (8) of the electric connection to a reference connecting means of the input port (9) of the receiving unit (2), wherein the signal connecting means of the input port (9) is connected to the reference connecting means of the input port (9) via a first series connection, wherein the first series connection comprises at least a first rectifying means and a first signal indication means, wherein each phase line is connected via a series connection of a signal rectifying means and a signal indication means to the reference line at another end (8) of the electric connection,
- generating an AC test signal.

11. The method of claim 11, wherein one of n signal connecting means of the output port (6) is connected to the signal part (11) of the transmitting unit (1) and the remaining n-1 connecting means of the output port (6) are connected to the reference part (12) of the transmitting unit (1) by selecting a switching state (A, B, C, D, E, F) of each of n-1 double switching elements.

12. The method of one of the claims 10 to 11, wherein the AC test signal is a square wave signal.

13. The method of claim 12, wherein the square wave signal has a frequency of 1 MHz.

## Patentansprüche

1. Testvorrichtung zum Testen einer elektrischen Verbindungsfähigkeit einer elektrischen Verbindung, insbesondere einer elektrischen Verbindung, die eine galvanische Trennung umfasst,
wobei die Verbindung wenigstens eine erste Phasenleitung und eine Referenzleitung umfasst,
wobei die Testvorrichtung eine Sendeeinheit (1) und eine Empfangseinheit (2) umfasst,
wobei die Sendeeinheit (1) über einen Eingangsanschluss (5), der wenigstens ein Signalverbindungsmittel und ein Referenzverbindungsmittel umfasst, mit einem Signalgenerator (4) verbindbar ist, wobei das Signalverbindungsmittel des Eingangsanschlusses (5) mit einem Signalteil (11) der Sendeeinheit (1) verbunden ist, wobei das Referenzverbindungsmittel des Eingangsanschlusses (5) mit einem Referenzteil (12) der Sendeeinheit (1) verbunden ist,
wobei die Sendeeinheit (1) über einen Ausgangsanschluss (6), der wenigstens ein Signalverbindungsmittel und ein Referenzverbindungsmittel umfasst, mit der elektrischen Verbindung verbindbar ist, wobei das Signalverbindungsmittel des Ausgangsanschlusses (6) mit der ersten Phasenleitung verbindbar ist, wobei das Referenzverbindungsmittel des Ausgangsanschlusses (6) mit der Referenzleitung verbindbar ist, wobei das Signalverbindungsmittel des Ausgangsanschlusses (6) mit dem Signalteil (11) verbindbar ist und das Referenzverbindungsmittel des Ausgangsanschlusses (6) mit dem Referenzteil (12) verbunden ist,
wobei die Empfangseinheit (2) einen Eingangsanschluss (9), wenigstens ein erstes Gleichrichtungsmittel und wenigstens ein erstes Signalanzeigemittel umfasst, wobei die Empfangseinheit (2) über den Eingangsanschluss (9), der wenigstens ein Signalverbindungsmittel und ein Referenzverbindungsmittel umfasst, mit der elektrischen Verbindung verbindbar ist, wobei das Signalverbindungsmittel des Eingangsanschlusses (9) mit der ersten Phasenleitung verbindbar ist, wobei das Referenzverbindungsmittel des Eingangsanschlusses (9) mit der Referenzleitung verbindbar ist, wobei das Signalverbindungsmittel des Eingangsanschlusses (9) über eine erste Reihenschaltung mit dem Referenzverbindungsmittel des Eingangsanschlusses (9) verbunden ist, wobei die erste Reihenschaltung wenigstens das erste Gleichrichtungsmittel und das erste Signalanzeigemittel umfasst, **dadurch gekennzeichnet, dass** die Sendeeinheit (1) über den Ausgangsanschluss (6) mit einem Mehrphasenkabel, das n Phasenleitungen umfasst, verbindbar ist, wobei
die Sendeeinheit (1) wenigstens ein Schaltmittel umfasst, wobei das Schaltmittel so ausgebildet und angeordnet ist, dass in jeder Schaltkonfiguration eines von n Signalverbindungsmitteln des Ausgangsanschlusses (6) mit dem Signalteil (11) der Sendeeinheit (1) verbunden ist, wobei die übrigen n-1 Signalverbindungsmittel des Ausgangsanschlusses (6) mit dem Referenzteil (12) der Sendeeinheit (1) verbunden sind, wobei die Empfangseinheit (2) über den Eingangsanschluss (9) mit dem Mehrphasenkabel verbindbar ist, wobei die Empfangseinheit (2) n Gleichrichtungsmittel und n Signalanzeigemittel umfasst, wobei jedes der n Signalverbindungsmittel des Eingangsanschlusses (9) über eine Reihenschaltung mit dem Referenzverbindungsmittel des Eingangsanschlusses (9) verbunden ist, wobei jede der Reihenschaltungen wenigstens ein Gleichrichtungsmittel und ein Signalanzeigemittel umfasst.

2. Testvorrichtung nach Anspruch 1, wobei das Signalanzeigemittel als eine Leuchtdiode (LED1, LED2, LED3, LED4) ausgebildet ist.

3. Testvorrichtung nach einem der Ansprüche 1 bis 2, wobei das Gleichrichtungsmittel als eine Diode (D1, D2, D3, D4) ausgebildet ist.

4. Testvorrichtung nach einem der Ansprüche 1 bis 3, wobei jede der Reihenschaltungen ein Widerstandelement umfasst oder alle der Reihenschaltungen über ein gemeinsames Widerstandselement mit dem Referenzverbindungsmittel des Eingangsanschlusses (9) verbunden sind.

5. Testvorrichtung nach einem der Ansprüche 1 bis 4, wobei ein kapazitives Element zu einem Stromweg, der das Signalanzeigemittel umfasst, parallelgeschaltet ist.

6. Testvorrichtung nach einem der Ansprüche 1 bis 5, wobei die Sendevorrichtung (1) n-1 Doppelschaltelemente umfasst, wobei in einem ersten Schaltzustand (A, C, E) ein erster Eingang des Doppelschaltelements mit einem ersten Ausgang des Doppelschaltelements verbunden ist und ein zweiter Eingang des Doppelschaltelements mit einem zweiten Ausgang des Doppelschaltelements verbunden ist, wobei in einem zweiten Schaltzustand (B, D, F) der erste Eingang des Doppelschaltelements mit einem dritten Ausgang des Doppelschaltelements verbunden ist und der zweite Eingang des Doppelschaltelements mit einem vierten Ausgang des Doppelschaltelements verbunden ist.

7. Testvorrichtung nach einem der Ansprüche 1 bis 6, wobei die Testvorrichtung einen Signalgenerator (4) umfasst, wobei der Signalgenerator (4) über den Eingangsanschluss (5) der Sendeeinheit (2) mit der Sendeeinheit (2) verbunden ist.

8. Testvorrichtung nach Anspruch 7, wobei der Signalgenerator (4) ein Rechteckwellengenerator ist.

9. Testvorrichtung nach einem der Ansprüche 1 bis 8, wobei der Ausgangsanschluss (6) der Sendeeinheit (1) vier Signalverbindungsmittel umfasst, wobei der Eingangsanschluss (9) der Empfangseinheit (2) vier Signalverbindungsmittel umfasst, wobei die Empfangseinheit (2) vier Reihenschaltungen eines Gleichrichtungsmittels und eines Signalanzeigemittels umfasst.

10. Verfahren zum Testen einer elektrischen Verbindungsfähigkeit einer elektrischen Verbindung, wobei die elektrische Verbindung wenigstens eine erste Phasenleitung und eine Referenzleitung umfasst, umfassend die folgenden Schritte:
- Verbinden eines Signalgenerators (4) mit einer Sendeeinheit (1) über einen Eingangsanschluss (5) der Sendeeinheit (1),
- Verbinden der ersten Phasenleitung an einem ersten Ende (7) der elektrischen Verbindung mit einem Signalverbindungsmittel eines Ausgangsanschlusses (6) der Sendeeinheit (1), wobei das Signalverbindungsmittel des Eingangsanschlusses (5) mit einem Signalteil (11) der Sendeeinheit (1) verbunden wird, wobei das Referenzverbindungsmittel des Eingangsanschlusses (5) mit einem Referenzteil (12) der Sendeeinheit (1) verbunden wird, wobei das Referenzverbindungsmittel des Ausgangsanschlusses (6) mit dem Referenzteil (12) verbunden wird,
- Verbinden des Signalverbindungsmittels des Ausgangsanschlusses (6) mit dem Signalteil (11),
wobei n Phasenleitungen der elektrischen Verbindung über den Ausgangsanschluss (6) am ersten Ende (7) der elektrischen Verbindung mit der Sendeeinheit (1) verbunden werden, wobei eines von n Signalverbindungsmitteln des Ausgangsanschlusses (6) mit dem Signalteil (11) der Sendeeinheit (1) verbunden wird und die übrigen n-1 Verbindungsmittel des Ausgangsanschlusses (6) mit dem Referenzteil (12) der Sendeeinheit (1) verbunden werden, indem ein Schaltmittel der Sendeeinheit (1) betätigt wird,
- Verbinden der Referenzleitung am ersten Ende (7) der elektrischen Verbindung mit dem Referenzverbindungsmittel des Ausgangsanschlusses (6) der Sendeeinheit (1),
- Verbinden der Phasenleitung an einem anderen Ende (8) der elektrischen Verbindung mit einem Signalverbindungsmittel eines Eingangsanschlusses (9) einer Empfangseinheit (2),
- Verbinden der Referenzleitung am anderen Ende (8) der elektrischen Verbindung mit einem Referenzverbindungsmittel des Eingangsanschlusses (9) der Empfangseinheit (2), wobei das Signalverbindungsmittel des Eingangsanschlusses (9) über eine erste Reihenschaltung mit dem Referenzverbindungsmittel des Eingangsanschlusses (9) verbunden wird, wobei die erste Reihenschaltung wenigstens ein erstes Gleichrichtungsmittel und ein erstes Signalanzeigemittel umfasst, wobei jede Phasenleitung über eine Reihenschaltung eines Signalgleichrichtungsmittels und eines Signalanzeigemittels mit der Referenzleitung an einem anderen Ende (8) der elektrischen Verbindung verbunden wird,
- Erzeugen eines Wechselstromtestsignals.

11. Verfahren nach Anspruch 11, wobei durch Auswählen eines Schaltzustands (A, B, C, D, E, F) von jedem der n-1 Doppelschaltelemente eines der n Signalverbindungsmittel des Ausgangsanschlusses (6) mit dem Signalteil (11) der Sendeeinheit (1) verbunden wird und die übrigen n-1 Verbindungsmittel des Ausgangsanschlusses (6) mit dem Referenzteil (12) der Sendeeinheit (1) verbunden werden.

12. Verfahren nach einem der Ansprüche 10 bis 11, wobei das Wechselstromtestsignal ein Rechteckwellensignal ist.

13. Verfahren nach Anspruch 12, wobei das Rechteckwellensignal eine Frequenz von 1 MHz hat.

## Revendications

1. Dispositif de contrôle pour contrôler une connectivité électrique d'une connexion électrique, en particulier une connexion électrique comprenant une séparation galvanique, dans lequel la connexion comprend au moins une première ligne de phase et une ligne de référence,
dans lequel le dispositif de contrôle comprend une unité de transmission (1) et une unité de réception (2),
dans lequel l'unité de transmission (1) peut être connectée à un générateur de signal (4) via un port d'entrée (5) comprenant au moins un moyen de connexion de signal et un moyen de connexion de référence,
dans lequel le moyen de connexion de signal du port d'entrée (5) est connecté à une partie de signal (11) de l'unité de transmission (1), dans lequel le moyen de connexion de référence du port d'entrée (5) est connecté à une partie de référence (12) de l'unité de transmission (1),
dans lequel l'unité de transmission (1) peut être connectée à la connexion électrique via un port de sortie (6) comprenant au moins un moyen de connexion de signal et un moyen de connexion de référence, dans lequel le moyen de connexion de signal du port de sortie (6) peut être connecté à la première ligne de phase, dans lequel le moyen de connexion de référence du port de sortie (6) peut être connecté à la ligne de référence, dans lequel le moyen de connexion de signal du port de sortie (6) peut être connecté à la partie de signal (11) et le moyen de connexion de référence du port de sortie (6) est connecté à la partie de référence (12), dans lequel l'unité de réception (2) comprend un port d'entrée (9), au moins un premier moyen redresseur et au moins un premier moyen d'indication de signal, dans lequel l'unité de réception (2) peut être connectée à la connexion électrique via le port d'entrée (9) comprenant au moins un moyen de connexion de signal et un moyen de connexion de référence, dans lequel le moyen de connexion de signal du port d'entrée (9) peut être connecté à la première ligne de phase, dans lequel le moyen de connexion de référence du port d'entrée (9) peut être connecté à la ligne de référence, dans lequel le moyen de connexion de signal du port d'entrée (9) est connecté au moyen de connexion de référence du port d'entrée (9) via une première connexion en série, dans lequel la première connexion en série comprend au moins le premier moyen redresseur et le premier moyen d'indication de signal, **caractérisé en ce que** l'unité de transmission (1) peut être connectée à un câble multiphase comprenant n lignes de phase via le port de sortie (6), dans lequel l'unité de transmission (1) comprend au moins un moyen de commutation, dans lequel le moyen de commutation est conçu et agencé de sorte que dans chaque configuration de commutation l'un de n moyens de connexion de signal du port de sortie (6) soit connecté à la partie de signal (11) de l'unité de transmission (1), dans lequel les n-1 moyens de connexion de signal restants du port de sortie (6) sont connectés à la partie de référence (12) de l'unité de transmission (1),
dans lequel l'unité de réception (2) peut être connectée au câble multiphase via le port d'entrée (9), dans lequel l'unité de réception (2) comprend n moyens redresseurs et n moyens d'indication de signal, dans lequel chacun des n moyens de connexion de signal du port d'entrée (9) est connecté au moyen de connexion de référence du port d'entrée (9) via une connexion en série, dans lequel chacune des connexions en série comprend au moins un moyen redresseur et un moyen d'indication de signal.

2. Dispositif de contrôle selon la revendication 1, dans lequel le moyen d'indication de signal est conçu sous forme de diode électroluminescente (LED1, LED2, LED3, LED4).

3. Dispositif de contrôle selon l'une des revendications 1 et 2, dans lequel le moyen redresseur est conçu sous forme de diode (D1, D2, D3, D4).

4. Dispositif de contrôle selon l'une des revendications 1 à 3, dans lequel chacune des connexions en série comprend un élément résistif ou toutes les connexions en série sont connectées au moyen de connexion de référence du port d'entrée (9) via un élément résistif commun.

5. Dispositif de contrôle selon l'une des revendications 1 à 4, dans lequel un élément capacitif est connecté en parallèle à un chemin de courant comprenant le moyen d'indication de signal.

6. Dispositif de contrôle selon l'une des revendications 1 à 5, dans lequel le dispositif de transmission (1) comprend n-1 éléments de commutation double, dans lequel une première entrée de l'élément de commutation double est connectée à une première sortie de l'élément de commutation double et une seconde entrée de l'élément de commutation double est connectée à une deuxième sortie de l'élément de commutation double dans un premier état de commutation (A, C, E), dans lequel la première entrée de l'élément de commutation double est connectée à une troisième sortie de l'élément de commutation double et la seconde entrée de l'élément de commutation double est connectée à une quatrième sortie de l'élément de commutation double dans un second état de commutation (B, D, F).

7. Dispositif de contrôle selon l'une des revendications 1 à 6, dans lequel le dispositif de contrôle comprend un générateur de signal (4), dans lequel le générateur de signal (4) est connecté à l'unité de transmission (2) via le port d'entrée (5) de l'unité de transmission (2).

8. Dispositif de contrôle selon la revendication 7, dans lequel le générateur de signal (4) est un générateur d'onde carrée.

9. Dispositif de contrôle selon l'une des revendications 1 à 8, dans lequel le port de sortie (6) de l'unité de transmission (1) comprend quatre moyens de connexion de signal, dans lequel le port d'entrée (9) de l'unité de réception (2) comprend quatre moyens de connexion de signal, dans lequel l'unité de réception (2) comprend quatre connexions en série d'un moyen redresseur et d'un moyen d'indication de signal.

10. Procédé de contrôle d'une connectivité électrique d'une connexion électrique, dans lequel la connexion électrique comprend au moins une première ligne de phase et une ligne de référence, comprenant les étapes de :
- connexion d'un générateur de signal (4) à une unité de transmission (1) via un port d'entrée (5) de l'unité de transmission (1),
- connexion de la première ligne de phase au niveau d'une première extrémité (7) de la connexion électrique à un moyen de connexion de signal d'un port de sortie (6) de l'unité de transmission (1), dans lequel le moyen de connexion de signal du port d'entrée (5) est connecté à une partie de signal (11) de l'unité de transmission (1), dans lequel le moyen de connexion de référence du port d'entrée (5) est connecté à une partie de référence (12) de l'unité de transmission (1), dans lequel le moyen de connexion de référence du port de sortie (6) est connecté à la partie de référence (12),
- connexion du moyen de connexion de signal du port de sortie (6) à la partie de signal (11), dans lequel n lignes de phase de la connexion électrique sont connectées à l'unité de transmission (1) via le port de sortie (6) au niveau de la première extrémité (7) de la connexion électrique, dans lequel l'un des n moyens de connexion de signal du port de sortie (6) est connecté à la partie de signal (11) de l'unité de transmission (1) et les n-1 moyens de connexion restants du port de sortie (6) sont connectés à la partie de référence (12) de l'unité de transmission (1) en exploitant un moyen de commutation de l'unité de transmission (1),
- connexion de la ligne de référence au niveau de la première extrémité (7) de la connexion électrique au moyen de connexion de référence du port de sortie (6) de l'unité de transmission (1),
- connexion de la ligne de phase au niveau d'une autre extrémité (8) de la connexion électrique à un moyen de connexion de signal d'un port d'entrée (9) d'une unité de réception (2),
- connexion de la ligne de référence au niveau de l'autre extrémité (8) de la connexion électrique à un moyen de connexion de référence du port d'entrée (9) de l'unité de réception (2), dans lequel le moyen de connexion de signal du port d'entrée (9) est connecté au moyen de connexion de référence du port d'entrée (9) via une première connexion en série, dans lequel la première connexion en série comprend au moins un premier moyen redresseur et un premier moyen d'indication de signal, dans lequel chaque ligne de phase est connectée via une connexion en série d'un moyen redresseur de signal et d'un moyen d'indication de signal à la ligne de référence au niveau d'une autre extrémité (8) de la connexion électrique,
- génération d'un signal de contrôle CA.

11. Procédé selon la revendication 11, dans lequel l'un des n moyens de connexion de signal du port de sortie (6) est connecté à la partie de signal (11) de l'unité de transmission (1) et les n-1 moyens de connexion restants du port de sortie (6) sont connectés à la partie de référence (12) de l'unité de transmission (1) en sélectionnant un état de commutation (A, B, C, D, E, F) de chacun des n-1 éléments de commutation double.

12. Procédé selon l'une des revendications 10 et 11, dans lequel le signal de contrôle CA est un signal carré.

13. Procédé selon la revendication 12, dans lequel le signal carré a une fréquence de 1 MHz.
